# EUROPEAN PATENT APPLICATION

(11) **EP 4 832 695 A1**
(43) Date of publication of application: **28.10.2026**
(21) Application number: 26173051.9
(22) Date of filing: 17.04.2026
(51) Int. Cl.: H10F 39/00

(54) **OPTICAL SENSOR AND ELECTRONIC DEVICE**

(30) Priority: 21.04.2025 CN 202520760788 U
(71) Applicant: Shenzhen Goodix Technology Co., Ltd., Shenzhen, Guangdong 518045 (CN)
(72) Inventor: WEI, Ya, Shenzhen, 518045 (CN); WU, Baoquan, Shenzhen, 518045 (CN)
(74) Representative: Metida

(57) **Abstract**

The present application discloses an optical sensor and an electronic device. The optical sensor includes a substrate, a first optical sensing chip, a light uniformizing structure, a first light-transmitting layer, and a light-shielding encapsulation layer. The first optical sensing chip is disposed on the substrate and electrically connected to the substrate; the light uniformizing structure is disposed above or on the first optical sensing chip; the first light-transmitting layer is disposed above or on the light uniformizing structure, and a vertical projection of the light uniformizing structure, and the first light-transmitting layer at least covers the effective photosensitive area of the first optical sensing chip; and the light-shielding encapsulation layer is disposed on the substrate and encapsulates side portions of the first optical sensing chip, the light uniformizing structure, and the first light-transmitting layer. The present application expands a half-power beamwidth of light above the first optical sensing chip.

## Description

### BACKGROUND OF THE INVENTION

### Technical Field

The present application relates to the technical field of sensors, in particular to an optical sensor and an electronic device.

### Description of Related Art

With the development of high-end consumer electronic products, there is an increasing demand for installing an optical sensor under a screen of an electronic device or integrating a variety of optical sensors. In a natural environment, light generally exhibits a Lambertian distribution. However, after the light passes through the screen of the electronic device, the screen tends to attenuate the light at a large angle. The optical sensor primarily detects light incident from above an optical sensing chip. Attenuating the light at the large angle by the screen will reduce an angle of effective light received by the optical sensing chip, thereby degrading application performance of the optical sensor.

### BRIEF SUMMARY OF THE INVENTION

In view of the shortcomings in the prior art, the present application provides an optical sensor and an electronic device. By arranging a light uniformizing structure on an effective photosensitive area of a first optical sensing chip, a half-power beamwidth of light above the first optical sensing chip is expanded, thereby increasing an angle of effective light received by the effective photosensitive area of the first optical sensing chip and further enhancing application performance of the optical sensor. The light uniformizing structure is embedded into an encapsulation structure without increasing the optical sensor's length or width, and also due to a small size of the light uniformizing structure in a height direction, a miniaturized design of the optical sensor can be achieved.

To achieve the above technical objective, in a first aspect of the present application, an optical sensor is disclosed, including a substrate, a first optical sensing chip, a light uniformizing structure, a first light-transmitting layer, and a light-shielding encapsulation layer.

The first optical sensing chip is disposed on the substrate and electrically connected to the substrate.

The light uniformizing structure is disposed above or on the first optical sensing chip and has a vertical projection at least covering the effective photosensitive area of the first optical sensing chip.

The first light-transmitting layer is disposed above or on the light uniformizing structure and has a vertical projection at least covering the effective photosensitive area of the first optical sensing chip.

The light-shielding encapsulation layer is disposed on the substrate and encapsulates side portions of the first optical sensing chip, the light uniformizing structure, and the first light-transmitting layer.

Further, the light uniformizing structure is of a structure with a flat upper surface and a lower surface provided with a plurality of first protrusions, and a first light-transmitting adhesive layer is disposed under the light uniformizing structure, having a refractive index smaller than that of the light uniformizing structure; and the light uniformizing structure is bonded to the first optical sensing chip or to a first transparent layer disposed on the first optical sensing chip by means of the first light-transmitting adhesive layer, and a vertical projection of the first transparent layer at least covers the effective photosensitive area of the first optical sensing chip.

Further, a difference in refractive index between the light uniformizing structure and the first light-transmitting adhesive layer is larger than 0.25.

Further, a difference in refractive index between the light uniformizing structure and the first light-transmitting adhesive layer is larger than 0.4.

Further, the light uniformizing structure is of the structure with the flat upper surface and the lower surface provided with the plurality of first protrusions; a planarization layer is disposed under the light uniformizing structure; a plurality of second protrusions are arranged on an upper surface of the planarization layer, and fill a gap between the first protrusions on the lower surface of the light uniformizing structure; a lower surface of the planarization layer is a flat plane; a refractive index of the planarization layer is smaller than that of the light uniformizing structure; the lower surface of the planarization layer is bonded to the first optical sensing chip or to a second transparent layer disposed on the first optical sensing chip; and a vertical projection of the second transparent layer at least covers the effective photosensitive area of the first optical sensing chip.

Further, a difference in refractive index between the light uniformizing structure and the planarization layer is larger than 0.25.

Further, a difference in refractive index between the light uniformizing structure and the planarization layer is larger than 0.4.

Further, the light uniformizing structure is of the structure with the flat upper surface and the lower surface provided with the plurality of first protrusions; a cofferdam is disposed around a periphery below the light uniformizing structure; the cofferdam is bonded to the first optical sensing chip to form an air gap between the light uniformizing structure and the first optical sensing chip, or the cofferdam is bonded to a third transparent layer disposed on the first optical sensing chip to form an air gap between the light uniformizing structure and the third transparent layer; a vertical projection of the air gap at least covers the effective photosensitive area of the first optical sensing chip; and a vertical projection of the third transparent layer at least covers the effective photosensitive area of the first optical sensing chip.

Further, the optical sensor further includes a first light filter layer, the first light filter layer being bonded onto the first light-transmitting layer or disposed between the first light-transmitting layer and the light uniformizing structure.

Further, the light uniformizing structure includes at least one light-concentrating unit and at least one light-blocking unit; the at least one light-blocking unit is correspondingly disposed below each light-concentrating unit; the at least one light-concentrating unit at least covers the effective photosensitive area of the first optical sensing chip; and the light-blocking unit corresponding to the light-concentrating unit is located between the light-concentrating unit and the effective photosensitive area of the first optical sensing chip; the light-blocking unit is used for blocking, after first incident light in incident light is concentrated by the light-concentrating unit corresponding to the light-blocking unit, concentrated light from reaching the effective photosensitive area of the first optical sensing chip; and an included angle between the first incident light and a normal line of a plane of the effective photosensitive area of the first optical sensing chip is smaller than an angle threshold which is smaller than 90 degrees.

Further, one light-blocking unit is correspondingly disposed below each light-concentrating unit; a central axis of the light-concentrating unit is perpendicular to the plane of the effective photosensitive area of the first optical sensing chip; the light-blocking unit corresponding to the light-concentrating unit intersects the central axis of the light-concentrating unit; and a projection of the light-blocking unit corresponding to the light-concentrating unit onto the first optical sensing chip is located within that of the light-concentrating unit onto the first optical sensing chip.

Further, the light uniformizing structure further includes a dielectric layer; the dielectric layer is disposed between the light-concentrating unit and the first optical sensing chip; and the at least one light-blocking unit is disposed within the dielectric layer.

Further, the light uniformizing structure further includes a light-transmitting encapsulation layer; the light-transmitting encapsulation layer is disposed on an upper surface of the dielectric layer; and the at least one light-concentrating unit is located within the light-transmitting encapsulation layer.

Further, the optical sensor further includes a second light filter layer, the second light filter layer being bonded onto the first light-transmitting layer, or disposed between the first light-transmitting layer and the light uniformizing structure, or disposed between the dielectric layer and the first optical sensing chip.

Further, the dielectric layer includes a first sub-dielectric layer and a second sub-dielectric layer arranged vertically; and the optical sensor further includes a third light filter layer, the third light filter layer being disposed between the first sub-dielectric layer and the second sub-dielectric layer.

Further, a refractive index of the light-concentrating unit is larger than that of the light-transmitting encapsulation layer.

Further, a difference in refractive index between the light-concentrating unit and the light-transmitting encapsulation layer is larger than 0.25.

Further, a difference in refractive index between the light-concentrating unit and the light-transmitting encapsulation layer is larger than 0.4.

Further, the light-blocking unit includes a circular light-blocking unit; and in a direction perpendicular to the first optical sensing chip, a central axis of the light-blocking unit corresponding to the light-concentrating unit coincides with that of the light-concentrating unit.

Further, the optical sensor includes a plurality of light-concentrating units, which are arranged in an array.

Further, a light-transmitting conductive shielding layer is disposed on a top layer of the optical sensor, and is electrically connected to a ground line of the substrate.

Further, the light-transmitting conductive shielding layer is electrically connected to the ground line of the substrate by means of a connecting member; the connecting member is one of a circuit board, a conductive pillar, or a bonding wire; and the light-shielding encapsulation layer encapsulates the connecting member.

Further, the light-transmitting conductive shielding layer is made of a material, including at least one of indium tin oxide, indium zinc oxide, transparent conductive ink, nano-silver, or a metal grid.

Further, the optical sensor further includes a processing chip; the processing chip is disposed on the substrate and electrically connected to the substrate; the first optical sensing chip is electrically connected to the processing chip; the first optical sensing chip and the processing chip are laid on the substrate, or the first optical sensing chip is disposed on the processing chip; and the light-shielding encapsulation layer encapsulates the processing chip.

Further, the optical sensor further includes a second optical sensing chip; the second optical sensing chip is disposed on the substrate and electrically connected to the substrate; a second light-transmitting layer is disposed on the second optical sensing chip, having a vertical projection at least covering an effective photosensitive area of the second optical sensing chip; and the light-shielding encapsulation layer encapsulates side portions of the second optical sensing chip and the second light-transmitting layer.

Further, the first optical sensing chip is used for detecting visible light, and the second optical sensing chip is used for detecting infrared light.

Further, the optical sensor further includes the processing chip; the processing chip is disposed on the substrate and electrically connected to the substrate; the first optical sensing chip and the second optical sensing chip are electrically connected to the processing chip; and the second optical sensing chip is disposed on the processing chip or the substrate.

Further, the light-shielding encapsulation layer is a black epoxy molding compound layer or a light-absorbing material layer.

To achieve the above technical objective, in a second aspect of the present application, an electronic device is disclosed, including the optical sensor described in the first aspect.

The present application has the following beneficial effects:

For the optical sensor of the present application, by arranging the light uniformizing structure on the effective photosensitive area of the first optical sensing chip, the half-power beamwidth of the light above the first optical sensing chip is expanded, thereby increasing the angle of the effective light received by the effective photosensitive area of the first optical sensing chip and further enhancing the application performance of the optical sensor. The light uniformizing structure is embedded into the encapsulation structure without increasing the optical sensor's length or width, and also due to the small size of the light uniformizing structure in the height direction, the miniaturized design of the optical sensor can be achieved.

### BRIEF DESCRIPTION OF THE SEVERAL VIEWS OF THE DRAWINGS

FIG. 1 is a schematic diagram of a light distribution in a screenless state;
FIG. 2 is a schematic diagram of a light distribution under a screen;
FIG. 3 is a longitudinal sectional view of an optical sensor according to a first embodiment of the present application;
FIG. 4 is a longitudinal sectional view of an optical sensor according to a second embodiment of the present application;
FIG. 5 is a longitudinal sectional view of an optical sensor according to a third embodiment of the present application;
FIG. 6 is a longitudinal sectional view of an optical sensor according to a fourth embodiment of the present application;
FIG. 7 is a longitudinal sectional view of an optical sensor according to a fifth embodiment of the present application;
FIG. 8 is longitudinal sectional view of an optical sensor according to a sixth embodiment of the present application;
FIG. 9 is a longitudinal sectional view of an optical sensor according to a seventh embodiment of the present application;
FIG. 10 is a longitudinal sectional view of an optical sensor according to an eighth embodiment of the present application;
FIG. 11 is a longitudinal sectional view of an optical sensor according to a ninth embodiment of the present application;
FIG. 12 is a longitudinal sectional view of an optical sensor according to a tenth embodiment of the present application;
FIG. 13 is a schematic diagram of light concentration according to an embodiment of the present application;
FIG. 14 is a schematic diagram of light concentration according to an embodiment of the present application;
FIG. 15 is a schematic diagram of light incidence according to an embodiment of the present application;
FIG. 16 is a longitudinal sectional view of an optical sensor according to an eleventh embodiment of the present application;
FIG. 17 is a longitudinal sectional view of an optical sensor according to a twelfth embodiment of the present application;
FIG. 18 is a longitudinal sectional view of an optical sensor according to a thirteenth embodiment of the present application;
FIG. 19 is a longitudinal sectional view of an optical sensor according to a fourteenth embodiment of the present application;
FIG. 20 is a longitudinal sectional view of an optical sensor according to a fifteenth embodiment of the present application;
FIG. 21 is a longitudinal sectional view of an optical sensor according to a sixteenth embodiment of the present application;
FIG. 22 is a longitudinal sectional view of an optical sensor according to a seventeenth embodiment of the present application;
FIG. 23 is a longitudinal sectional view of an optical sensor according to an eighteenth embodiment of the present application;
FIG. 24 is a longitudinal sectional view of an optical sensor according to a nineteenth embodiment of the present application; and
FIG. 25 is a longitudinal sectional view of an optical sensor according to a twentieth embodiment of the present application.

### Reference numerals in the drawings:

1. substrate; 2. first optical sensing chip; 3. light uniformizing structure; 31. light-concentrating unit; 32. light-blocking unit; 33. dielectric layer; 331. first sub-dielectric layer; 332. second sub-dielectric layer; 34. light-transmitting encapsulation layer; 4. first light-transmitting layer; 5. light-shielding encapsulation layer; 6. first light-transmitting adhesive layer; 7. first transparent layer; 8. planarization layer; 9. second transparent layer; 10. cofferdam; 11. air gap; 12. third transparent layer; 13. first light filter layer; 14. second light filter layer; 15. third light filter layer; 16. light-transmitting conductive shielding layer; 17. connecting member; 18. processing chip; 19. second optical sensing chip; 20. bonding wire; 21. second light-transmitting layer; and 22. light-transmitting adhesive.

### DETAILED DESCRIPTION OF THE INVENTION

By combining the drawings of the description, the optical sensor and electronic device provided in the present application will be explained and demonstrated in detail below.

In practical application, light detection performance of an optical sensor is more accurate if an intensity of received light is stronger than half of that of incident light at 0 degree. Light meeting this intensity criterion is referred to as effective light. Here, light incident at 0 degree refers to light incident at an included angle of 0 degree relative to a normal line of a photosensitive plane, i.e., light in a normal direction, hereinafter referred to as 0-degree light. On a light intensity distribution curve, an angular range where the light intensity is half of that of the 0-degree light is called a half-power beamwidth. Therefore, in the practical application, the half-power beamwidth is typically used as an application scenario for light detection and also serves as a screen dimming threshold.

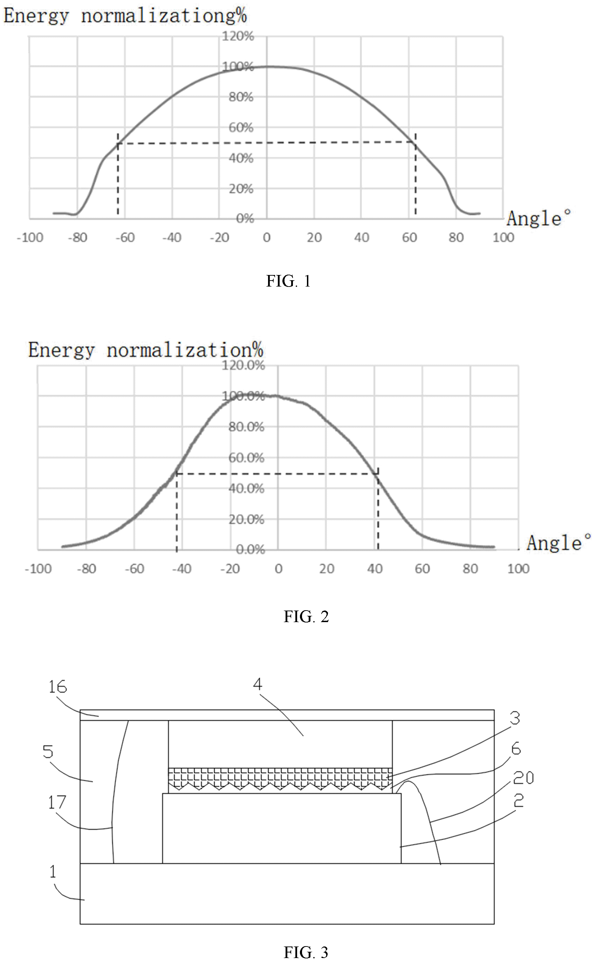

As shown in FIGs. 1 and 2, the intensity of the 0-degree light is the highest, and the light intensity gradually weakens from the 0-degree light toward both sides of positive and negative half axes. Under a same incident light intensity, FIG. 1 is a schematic diagram of a light distribution in a screenless state. As shown in FIG. 1, in the screenless state, the half-power beamwidth of the light is approximately 124 degrees, and a half-angle of the half-power beamwidth (a positive or negative half-axis angle) is about 62 degrees. FIG. 2 is a schematic diagram of a light distribution under a screen. Light passing through a screen of a certain electronic device has a half-power beamwidth of about 82 degrees, and a half-angle of the half-power beamwidth (the positive or negative half-axis angle) is only about 41 degrees. This demonstrates that the screen attenuates light at a large angle, narrowing an application field of view for under-screen light detection. Consequently, an angle of effective light received by the optical sensor is reduced, leading to degradation in application performance of the optical sensor.

This embodiment specifically discloses an optical sensor. As shown in FIGs. 3 to 12 and FIGs. 16 to 19, the optical sensor includes a substrate 1, a first optical sensing chip 2, a light uniformizing structure 3, a first light-transmitting layer 4, and a light-shielding encapsulation layer 5. The first optical sensing chip 2 is disposed on the substrate 1, electrically connected to the substrate 1, and is fixedly bonded to the substrate 1 by means of silver paste, a die attach film (DAF), or a water-based optical adhesive. The substrate 1 is provided with a circuit, serving as a carrier, to enable signal interconnection with an external signal. The first optical sensing chip 2 is electrically connected to the substrate 1 by means of a bonding wire 20. The first optical sensing chip 2 is capable of receiving an external light signal and converting the received light signal to an electrical signal. In this embodiment, the first optical sensing chip 2 is used for detecting visible light, and the optical sensor functions as an ambient light sensor or a color temperature sensor.

The light uniformizing structure 3 is disposed above or on the first optical sensing chip 2, and vertical projection of the light uniformizing structure 3 at least covers an effective photosensitive area (Active Area, AA) of the first optical sensing chip 2. Preferably, an area of the vertical projection of the light uniformizing structure 3 is larger than that of the effective photosensitive area of the first optical sensing chip 2, ensuring that the light uniformizing structure 3 receives sufficient light and uniformize it. The uniformized light then enters the effective photosensitive area of the first optical sensing chip 2, maximizing an amount of the effective light received by the effective photosensitive area of the first optical sensing chip 2.

The first light-transmitting layer 4 is disposed above or on the light uniformizing structure 3, and vertical projection of the first light-transmitting layer 4 at least covers the effective photosensitive area of the first optical sensing chip 2. Preferably, an area of the vertical projection of the first light-transmitting layer 4 is larger than that of the effective photosensitive area of the first optical sensing chip 2. The vertical projection of the light uniformizing structure 3 either coincides with that of the first light-transmitting layer 4 or lies within the vertical projection of the first light-transmitting layer 4. The first light-transmitting layer 4 protects the light uniformizing structure 3 while ensuring that sufficient light enters the light uniformizing structure 3.

In this embodiment, a vertical direction refers to a direction perpendicular to the substrate 1.

Optionally, the first light-transmitting layer 4 is a glass plate or a transparent organic plate. The transparent organic plate may be a phenolic resin plate, a polyethylene terephthalate-1,4-cyclohexanedimethyleneterephthalate (PETG) plate, a polymethyl methacrylate (PMMA) plate, a polyimide (PI) plate, or a polyethylene glycol terephthalate (PET) plate.

The light-shielding encapsulation layer 5 is disposed on the substrate 1 and encapsulates the side portions of the first optical sensing chip 2, the light uniformizing structure 3, and the first light-transmitting layer 4. A top of the first light-transmitting layer 4 is exposed outside the light-shielding encapsulation layer 5, and the light-shielding encapsulation layer 5 does not affect an effective amount of incident light. The light-shielding encapsulation layer 5 encapsulates the bonding wire 20, providing sealed protection for it. The light-shielding encapsulation layer 5 solves the problem of light leakage from a side surface of the optical sensor, prevents light reflection within a transparent encapsulation which will introduce optical signal interference, increases a signal-to-noise ratio, and enhances accuracy of optical signal recognition. In this way, the optical sensor can be improved in reliability, meeting a requirement for a more complex application environment.

Optionally, the light-shielding encapsulation layer 5 is a black epoxy molding compound (Epoxy Molding Compound, EMC) layer or a light-absorbing material layer. The black epoxy molding compound layer is made by filling a transparent EMC with a black material, which improves a coefficient of thermal expansion compared with the transparent EMC, thereby solving the problems of warpage and high stress of the optical sensor and reducing a reliability risk brought by the stress.

The light uniformizing structure 3 in this embodiment can achieve a light-uniformizing effect, expanding the half-power beamwidth of the light above the first optical sensing chip 2, i.e., enlarging an angle of the effective field of view above the first optical sensing chip 2. This increases the angle of the effective light received by the effective photosensitive area of the first optical sensing chip 2, thereby enhancing the application performance of the first optical sensing chip 2. The light uniformizing structure 3 is embedded into an encapsulation structure, without increasing the optical sensor's length or width, and also due to the small size of the light uniformizing structure 3 in the height direction, the miniaturized design of the optical sensor can be achieved.

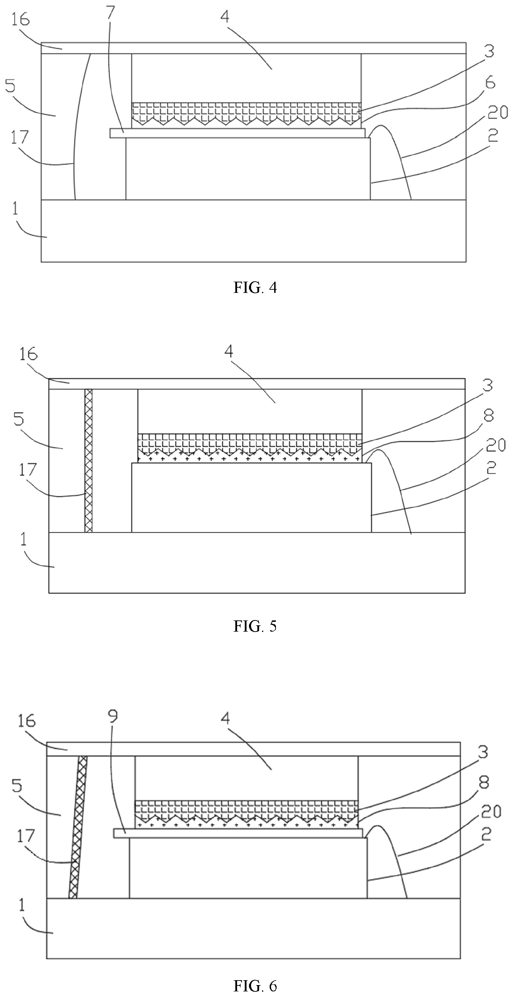

In some embodiments, the light uniformizing structure 3 is of the structure with the flat upper surface and the lower surface provided with the plurality of first protrusions, that is, the light uniformizing structure 3 is a diffuser. The first protrusions on the surface of the light uniformizing structure 3 are micro-protrusions, which reflect the originally strongest 0-degree incident light, and refract and scatter it into light at other angles, thereby weakening the intensity of light in the normal direction while strengthening an intensity of light at other angles. This results in a batwing-shaped distribution of the intensity of the light above the first optical sensing chip 2. Since the half-power beamwidth corresponds to a beam angle at which the light intensity is half of that of the 0-degree light, weakening the intensity of the 0-degree light effectively expands the half-power beamwidth in another way, and enlarges the angle of the effective field of view above the first optical sensing chip 2, which allows the effective photosensitive area of the first optical sensing chip 2 to receive the effective light from a larger angle, and enables a light detection function at a larger angle. As shown in FIGs. 3 and 4, a first light-transmitting adhesive layer 6 is arranged under the light uniformizing structure 3; a refractive index of the first light-transmitting adhesive layer 6 is smaller than that of the light uniformizing structure 3, ensuring a refractive index difference across a morphological interface of the light uniformizing structure 3 to achieve a good light uniformizing effect. Preferably, a difference in refractive index between the light uniformizing structure 3 and the first light-transmitting adhesive layer 6 is larger than 0.25, and more preferably, is larger than 0.4, which ensures a better light uniformizing effect. Light transmittance of the first light-transmitting adhesive layer 6 is larger than or equal to that of the first light-transmitting layer 4. The first light-transmitting adhesive layer 6 may be a transparent adhesive layer, the DAF, or the water-based optical adhesive. In one embodiment, as shown in FIG. 3, the light uniformizing structure 3 is bonded to the first optical sensing chip 2 by means of the first light-transmitting adhesive layer 6. In another embodiment, as shown in FIG. 4, the light uniformizing structure 3 is bonded to a first transparent layer 7 disposed on the first optical sensing chip 2 by means of the first light-transmitting adhesive layer 6, and a vertical projection of the first transparent layer 7 at least covers the effective photosensitive area of the first optical sensing chip 2. The first light-transmitting adhesive layer 6 not only achieves fixed bonding between the light uniformizing structure 3 and a structure below it, but also ensures a light uniformizing effect of the light uniformizing structure 3.

In the embodiment shown in FIG. 4, the first transparent layer 7 is used for carrying the light uniformizing structure 3. The vertical projection of the first transparent layer 7 at least covers the effective photosensitive area of the first optical sensing chip 2, meaning that an area of the vertical projection of the first transparent layer 7 is equal to or larger than that of the effective photosensitive area of the first optical sensing chip 2. Preferably, the area of the vertical projection of the first transparent layer 7 is larger than that of the effective photosensitive area of the first optical sensing chip 2. As shown in FIG. 4, the first transparent layer 7 may extend beyond the first optical sensing chip 2 in a direction where no bonding wire 20 is disposed, providing a large carrying area for the light uniformizing structure 3. This facilitates installation and fixation of the light uniformizing structure 3 and allows for a larger design of the light uniformizing structure 3, ensuring a better light uniformizing effect.

Optionally, the first transparent layer 7 is the glass plate or the transparent organic plate. The transparent organic plate may be the phenolic resin plate, the polyethylene terephthalate-1,4-cyclohexanedimethyleneterephthalate (PETG) plate, the polymethyl methacrylate (PMMA) plate, the polyimide (PI) plate, or the polyethylene glycol terephthalate (PET) plate. In a case of the first transparent layer 7 being the glass plate, the first transparent layer 7 is fixedly bonded to the first optical sensing chip 2 by means of a light-transmitting adhesive 22 (not shown in the drawing). In a case of the first transparent layer 7 being the transparent organic plate, the transparent organic plate may be fixedly bonded to the first optical sensing chip 2 by means of the light-transmitting adhesive 22 (not shown in the drawing), or may be directly molded onto the first optical sensing chip 2 using a transparent organic material. A specific method for bonding the first transparent layer 7 to the first optical sensing chip 2 is adjusted based on hardness of the transparent organic material after it is formed into a plate. Preferably, the light-transmitting adhesive 22 is a DAF adhesive or the water-based optical adhesive.

This embodiment further provides a method for preparing the optical sensor shown in FIG. 3, specifically including the following steps of:
S1, bonding a first optical sensing chip 2 to a substrate 1 by means of silver paste, a DAF, or a water-based optical adhesive, and connecting it to the substrate 1 by means of a bonding wire 20 to enable electrical interconnection;
S2. forming a light uniformizing structure 3 on a first light-transmitting layer 4 by means of nano-imprinting, dry etching, or wet etching, and then, bonding the light uniformizing structure 3 to the first optical sensing chip 2 by means of the first light-transmitting adhesive layer 6, with the first light-transmitting layer 4 located on the light uniformizing structure 3;
S3. encapsulating the first optical sensing chip 2, the first light-transmitting adhesive layer 6, the light uniformizing structure 3, and the first light-transmitting layer 4 above the substrate 1 with a light-shielding or light-absorbing material on an upper surface of the substrate 1, so as to comprehensively protect the first optical sensing chip 2, the first light-transmitting adhesive layer 6, the light uniformizing structure 3, and the first light-transmitting layer 4; and
S4. exposing a top surface of the first light-transmitting layer 4 by means of a grinding process.

Alternatively, in the step S3, when the first optical sensing chip 2, the first light-transmitting adhesive layer 6, the light uniformizing structure 3, and the first light-transmitting layer 4 are encapsulated with the light-shielding or light-absorbing material, an open mold process may be used to directly expose the top surface of the first light-transmitting layer 4, allowing light to enter an effective photosensitive area of the first optical sensing chip 2.

While in a method for preparing the optical sensor shown in FIG. 4, before the step S2, the first transparent layer 7 is first bonded onto the first optical sensing chip 2; and then, when the step S2 is performed, the light uniformizing structure 3 is bonded to the first transparent layer 7 by means of the first light-transmitting adhesive layer 6.

In some embodiments, as shown in FIGs. 5 and 6, the light uniformizing structure 3 is of a structure with a flat upper surface and a lower surface provided with a plurality of first protrusions. The first protrusions are used for reflecting, refracting, and scattering the 0-degree light, thereby weakening the intensity of the light in the normal direction, expanding the half-power beamwidth, and enlarging the angle of the effective field of view above the first optical sensing chip 2. In this way, the effective photosensitive area of the first optical sensing chip 2 can receive the effective light from the larger angle, and the light detection function at the larger angle is provided. The planarization layer 8 is disposed under the light uniformizing structure 3; a plurality of second protrusions are arranged on an upper surface of the planarization layer 8, and fill a gap between the first protrusions on the lower surface of the light uniformizing structure 3; the lower surface of the planarization layer 8 is a flat plane; and a refractive index of the planarization layer 8 is smaller than that of the light uniformizing structure 3, ensuring the refractive index difference across the morphological interface of the light uniformizing structure 3 to achieve the good light uniformizing effect. Preferably, a difference in refractive index between the light uniformizing structure 3 and the planarization layer 8 is larger than 0.25, and more preferably, is larger than 0.4, which ensures the better light uniformizing effect. The planarization layer 8 may be an adhesive film or any other material with a refractive index smaller than that of the light uniformizing structure 3, and the present application does not impose specific limitations as long as its refractive index difference relative to the light uniformizing structure 3 is satisfied. In one embodiment, as shown in FIG. 5, the lower surface of the planarization layer 8 is bonded to the first optical sensing chip 2. In another embodiment, as shown in FIG. 6, the lower surface of the planarization layer 8 is bonded to a second transparent layer 9 disposed on the first optical sensing chip 2, and a vertical projection of the second transparent layer 9 at least covers the effective photosensitive area of the first optical sensing chip 2. The planarization layer 8 ensures the light uniformizing effect of the light uniformizing structure 3 while also facilitating it to be fixedly bonded to its underlying structure by means of its flat lower surface.

In a case of the planarization layer 8 being an adhesive layer, it can be directly bonded to the first optical sensing chip 2 or to the second transparent layer 9 disposed on the first optical sensing chip 2. The planarization layer 8 may also be made of other materials and then bonded to the first optical sensing chip 2 or the second transparent layer 9 disposed on the first optical sensing chip 2 by means of the light-transmitting adhesive 22. A refractive index of the light-transmitting adhesive 22 is not specially required; and commonly used light-transmitting adhesive 22 with a refractive index of 1.4 - 1.6, such as the DAF adhesive or the water-based optical adhesive, may be employed.

In the embodiment shown in FIG. 6, the second transparent layer 9 is used for carrying the light uniformizing structure 3 and the planarization layer 8. The vertical projection of the second transparent layer 9 at least covers the effective photosensitive area of the first optical sensing chip 2, meaning that an area of the vertical projection of the second transparent layer 9 is equal to or larger than that of the effective photosensitive area of the first optical sensing chip 2. Preferably, the area of the vertical projection of the second transparent layer 9 is larger than that of the effective photosensitive area of the first optical sensing chip 2. As shown in FIG. 6, the second transparent layer 9 may extend beyond the first optical sensing chip 2 in the direction where no bonding wire 20 is disposed, providing a large carrying area for the light uniformizing structure 3 and the planarization layer 8. This facilitates installation and fixation of the light uniformizing structure 3 and the planarization layer 8 and allows for the larger design of the light uniformizing structure 3, ensuring the better light uniformizing effect.

Optionally, the second transparent layer 9 is the glass plate or the transparent organic plate. The transparent organic plate may be the phenolic resin plate, the polyethylene terephthalate-1,4-cyclohexanedimethyleneterephthalate (PETG) plate, the polymethyl methacrylate (PMMA) plate, the polyimide (PI) plate, or the polyethylene glycol terephthalate (PET) plate. In a case of the second transparent layer 9 being the glass plate, the second transparent layer 9 is fixedly bonded to the first optical sensing chip 2 by means of the light-transmitting adhesive 22. In a case of the second transparent layer 9 being the transparent organic plate, the transparent organic plate may be fixedly bonded to the first optical sensing chip 2 by means of the light-transmitting adhesive 22, or may be directly molded onto the first optical sensing chip 2 using the transparent organic material. A specific method for bonding the second transparent layer 9 to the first optical sensing chip 2 is adjusted based on hardness of the transparent organic material after it is formed into a plate. Preferably, the light-transmitting adhesive 22 is a DAF adhesive or the water-based optical adhesive.

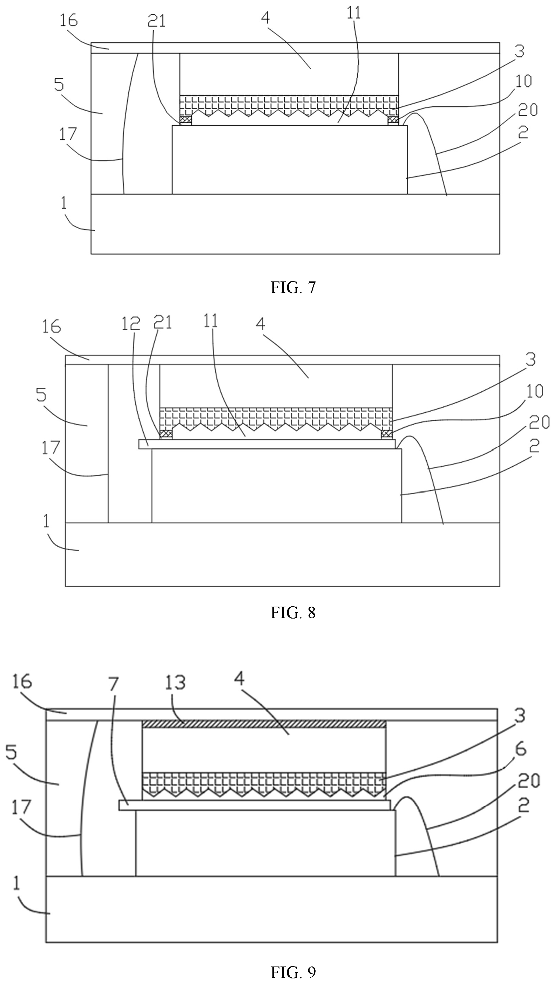

In some embodiments, as shown in FIGs. 7 and 8, the light uniformizing structure 3 is of a structure with a flat upper surface and a lower surface provided with a plurality of first protrusions. The first protrusions are used for reflecting, refracting, and scattering the 0-degree light, thereby weakening the intensity of the light in the normal direction, expanding the half-power beamwidth, and enlarging the angle of the effective field of view above the first optical sensing chip 2. In this way, the effective photosensitive area of the first optical sensing chip 2 can receive the effective light from the larger angle, and the light detection function at the larger angle is provided. A cofferdam 10 is disposed around a periphery below the light uniformizing structure 3. The cofferdam 10 is of a ring-shaped structure, such as in a circular shape, a rectangular shape, etc., which will not be specifically limited in the present application. In one embodiment, as shown in FIG. 7, the cofferdam 10 is bonded to the first optical sensing chip 2 to form an air gap 11 between the light uniformizing structure 3 and the first optical sensing chip 2. In another embodiment, as shown in FIG. 8, the cofferdam 10 is bonded to a third transparent layer 12 disposed on the first optical sensing chip 2 to form an air gap 11 between the light uniformizing structure 3 and the third transparent layer 12. A vertical projection of the air gap 11 at least covers the effective photosensitive area of the first optical sensing chip 2, and a vertical projection of the third transparent layer 12 at least covers the effective photosensitive area of the first optical sensing chip 2. The air gap 11 is laterally enclosed by the cofferdam 10, and an outer surface of the cofferdam 10 is encapsulated by the light-shielding encapsulation layer 5. The cofferdam 10 supports the light uniformizing structure 3 in a vertical direction, thereby forming the air gap 11 between the light uniformizing structure 3 and either the first optical sensing chip 2 under it or the third transparent layer 12 disposed on the first optical sensing chip 2. A refractive index of air is smaller than that of the light uniformizing structure 3, creating a refractive index difference across the morphological interface of the light uniformizing structure 3 to ensure the good uniformizing effect.

The cofferdam 10 may be made of the same material as the light uniformizing structure 3, or may be made of an adhesive material or other materials. The present application does not impose specific limitations on this, nor does it restrict a refractive index of the cofferdam 10.

In a case of the cofferdam 10 being made of the same material as the light uniformizing structure 3, the light uniformizing structure 3 and the cofferdam 10 may be formed directly on the first light-transmitting layer 4 by means of nano-imprinting, dry etching, or wet etching. In a case of the cofferdam 10 being made of the adhesive material, the cofferdam 10 may be formed by dispensing the adhesive or die-cutting the DAF adhesive on the first optical sensing chip 2 or on the third transparent layer 12 disposed on the first optical sensing chip 2. A specific method for manufacturing the cofferdam 10 is adjusted depending on its specific material.

In the embodiment shown in FIG. 8, the third transparent layer 12 is used for carrying the light uniformizing structure 3 and the planarization layer 8. A vertical projection of the third transparent layer 12 at least covers the effective photosensitive area of the first optical sensing chip 2, meaning that an area of the vertical projection of the third transparent layer 12 is equal to or larger than that of the effective photosensitive area of the first optical sensing chip 2. Preferably, the area of the vertical projection of the third transparent layer 12 is larger than that of the effective photosensitive area of the first optical sensing chip 2. The third transparent layer 12 may extend beyond the first optical sensing chip 2 in the direction where no bonding wire 20 is disposed, providing a large carrying area for the light uniformizing structure 3 and the cofferdam 10. This facilitates installation and fixation of the light uniformizing structure 3 and the cofferdam 10 and allows for larger designs of the light uniformizing structure 3 and the cofferdam 10, thereby making a larger area of the air gap 11 and ensuring the better light uniformizing effect.

Optionally, the third transparent layer 12 is the glass plate or the transparent organic plate. The transparent organic plate may be the phenolic resin plate, the polyethylene terephthalate-1,4-cyclohexanedimethyleneterephthalate (PETG) plate, the polymethyl methacrylate (PMMA) plate, the polyimide (PI) plate, or the polyethylene glycol terephthalate (PET) plate. In a case of the third transparent layer 12 being the glass plate, the third transparent layer 12 is fixedly bonded to the first optical sensing chip 2 by means of the light-transmitting adhesive 22. In a case of the third transparent layer 12 being the transparent organic plate, the transparent organic plate may be fixedly bonded to the first optical sensing chip 2 by means of the light-transmitting adhesive 22, or may be directly molded onto the first optical sensing chip 2 using the transparent organic material. A specific method for bonding the third transparent layer 12 to the first optical sensing chip 2 is adjusted based on hardness of the transparent organic material after it is formed into a plate. Preferably, the light-transmitting adhesive 22 is a DAF adhesive or the water-based optical adhesive.

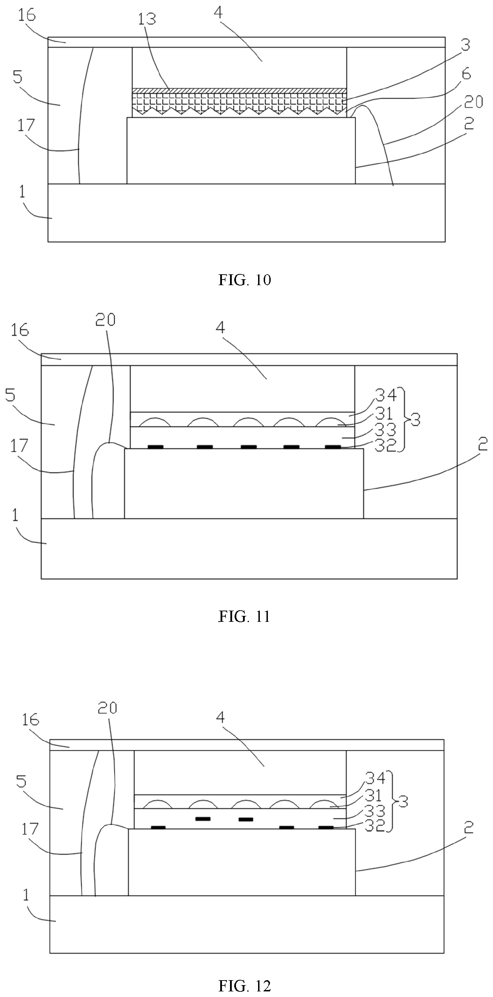

In some embodiments, as shown in FIGs. 9 and 10, the optical sensor further includes a first light filter layer 13, used for allowing light of a specific wavelength to enter the effective photosensitive area of the first optical sensing chip 2. In one embodiment, as shown in FIG. 9, the first light filter layer 13 is bonded onto the first light-transmitting layer 4. In another embodiment, as shown in FIG. 10, the first light filter layer 13 is disposed between the first light-transmitting layer 4 and the light uniformizing structure 3, with its upper surface bonded to the first light-transmitting layer 4 and its lower surface bonded to the light uniformizing structure 3. The vertical projection of the first light filter layer 13 at least covers the effective photosensitive area of the first optical sensing chip 2. The first light filter layer 13 may be a color filter layer or an infrared cut filter layer.

In some embodiments, as shown in FIGs. 11 and 12, the light uniformizing structure 3 includes at least one light-concentrating unit 31 and at least one light-blocking unit 32, where at least one light-blocking unit 32 is correspondingly disposed below each light-concentrating unit 31. The at least one light-concentrating unit 31 at least covers the effective photosensitive area of the first optical sensing chip 2, and the light-blocking unit 32 corresponding to the light-concentrating unit 31 is located between the light-concentrating unit 31 and the effective photosensitive area of the first optical sensing chip 2. The light-blocking unit 32 is used for blocking, after first incident light in incident light is concentrated by the light-concentrating unit 31 corresponding to the light-blocking unit 32, concentrated light from reaching the effective photosensitive area of the first optical sensing chip 2; and an included angle between the first incident light and a normal line of a plane of the effective photosensitive area of the first optical sensing chip 2 is smaller than an angle threshold which is smaller than 90 degrees.

The first incident light in the incident light, which forms the included angle smaller than the angle threshold with the normal line of the plane of the effective photosensitive area of the first optical sensing chip 2, is concentrated by the light-concentrating unit 31 and then blocked by the light-blocking unit 32, preventing it from illuminating the effective photosensitive area of the first optical sensing chip 2. Incident light that forms an included angle larger than or equal to the angle threshold with the normal line of the plane of the effective photosensitive area of the first optical sensing chip 2 can normally illuminate the effective photosensitive area of the first optical sensing chip 2 after it passes through the light-concentrating unit 31. As a result, an illumination intensity of small-angle incident light detected by the effective photosensitive area of the first optical sensing chip 2 becomes weaker, while an illumination intensity of large-angle incident light detected by the effective photosensitive area of the first optical sensing chip 2 remains unchanged. Consequently, when the effective photosensitive area of the first optical sensing chip 2 detects the illumination intensity of the incident light, under a same illumination intensity, a difference between the illumination intensity of the large-angle incident light detected by the effective photosensitive area of the first optical sensing chip 2 and that of the small-angle incident light is small. This enhances photosensitivity of the first optical sensing chip 2 to the large-angle light, thereby increasing the angle at which the effective photosensitive area of the first optical sensing chip 2 receives the effective light, improving performance of the optical sensor, and enabling the light detection function at the larger angle.

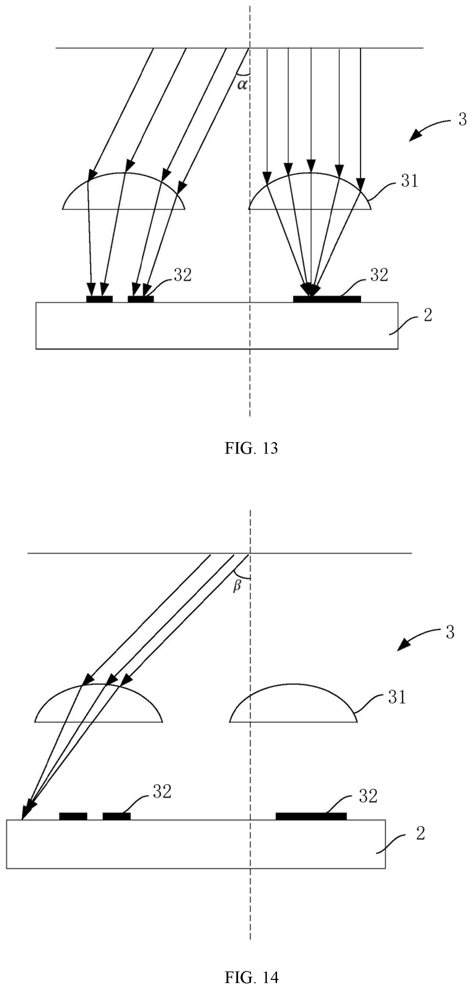

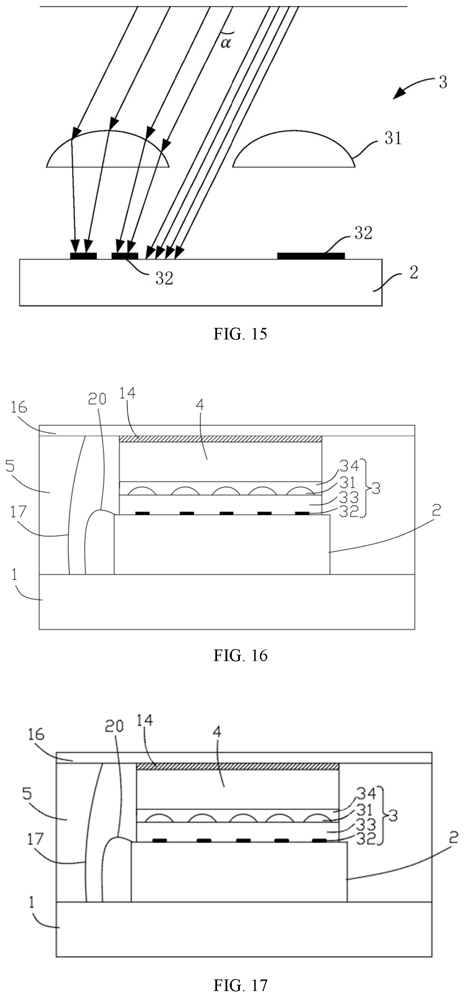

In an example, when being included between each light-concentrating unit 31 and the effective photosensitive area of the first optical sensing chip 2, a plurality of light-blocking units 32 may be spliced in one plane in parallel to form a large light-blocking unit 32, or they may be dispersed in parallel in one plane, or they may be arranged in different planes, which will not be limited herein. The light-concentrating unit 31 may concentrate the light. Specifically, after the light illuminates the light-concentrating unit 31, it will refract, causing a change on its propagation direction. Light illuminating different positions of the light-concentrating unit 31 will be concentrated, and the light-blocking unit 32 can block the concentrated light. FIG. 13 is a schematic diagram of light concentration provided by an embodiment of the present application. As shown in FIG. 13, light propagates to the light-concentrating unit 31, and then refracts after it passes through the light-concentrating unit 31, causing a change on a light propagation direction. The light-blocking unit 32 is disposed between the light-concentrating unit 31 opposite thereto and the effective photosensitive area of the first optical sensing chip 2. The first incident light refracts with changing its propagation direction after it passes through the light-concentrating unit 31. The light illuminates the light-blocking unit 32, and is blocked by the light-blocking unit 32 from illuminating the effective photosensitive area of the first optical sensing chip 2. The first incident light refers to light which forms the included angle smaller than the angle threshold with the normal line of the plane of the effective photosensitive area of the first optical sensing chip 2. For example, FIG. 13 illustrates first incident light at an included angle α and first incident light at an included angle of 0 degree (i.e., vertically incident) receptively. The included angle α between the first incident light and the normal line is smaller than the angle threshold. FIG. 14 is a schematic diagram of another form of light concentration provided by an embodiment of the present application. As shown in FIG. 14, second incident light in the incident light, which forms an included angle with the normal line of the plane of the effective photosensitive area of the first optical sensing chip 2 is larger than or equal to the angle threshold, cannot be blocked by the light-blocking unit 32 after it passes through the light-concentrating unit 31, and will directly illuminate the effective photosensitive area of the first optical sensing chip 2. That is, an included angle β in FIG. 14 is larger than or equal to the angle threshold. It should be understood that, due to the characteristics of the light, light, which forms an included angle larger than 90 degrees with the normal line of the plane of the effective photosensitive area of the first optical sensing chip 2, will not illuminate the effective photosensitive area of the first optical sensing chip 2. Therefore, the angle threshold is smaller than 90 degrees. It should be noted that, due to the presence of the light-blocking unit 32, the first incident light, which forms the included angle smaller than the angle threshold with the normal line of the plane of the effective photosensitive area of the first optical sensing chip 2, is blocked by the light-blocking unit 32 after it passes through the light-concentrating unit 31, while the second incident light, which forms the included angle larger than or equal to the angle threshold with the normal line of the plane of the effective photosensitive area of the first optical sensing chip 2, will not be being blocked by the light-blocking unit 32 after it passes through the light-concentrating unit 31, and can directly illuminate the effective photosensitive area of the first optical sensing chip 2. It should also be noted that, in an embodiment of the present application, the effective photosensitive area of the first optical sensing chip 2 is not completely covered by the at least one light-concentrating unit 31. Therefore, partial light in the first incident light, which forms the included angle smaller than the angle threshold with the normal line of the plane of the effective photosensitive area of the first optical sensing chip 2, does not pass through the light-concentrating unit 31. Instead, it passes through positions where no light-concentrating unit 31 is disposed and then can illuminate the effective photosensitive area of the first optical sensing chip 2. For example, FIG. 15 is a schematic diagram of light incidence provided by an embodiment of the present application. As shown in FIG. 15, partial light in the first incident light at the included angle α illuminates the effective photosensitive area of the first optical sensing chip 2 through a gap between the light-concentrating units 31. Therefore, the optical sensor in this embodiments of the present application reduces an amount of the first incident light, which forms the included angle smaller than the angle threshold with the normal line of the plane of the effective photosensitive area of the first optical sensing chip 2, reaching the effective photosensitive area of the first optical sensing chip 2, rather than all of the first incident light is blocked. As for the second incident light, which forms the included angle larger than or equal to the angle threshold with the normal line of the plane of the effective photosensitive area of the first optical sensing chip 2, an amount of light reaching the effective photosensitive area of the first optical sensing chip 2 remains unchanged. Thus, the present application can enlarge the angle of the effective field of view above the first optical sensing chip 2, enabling the optical sensor to detect the illumination intensity with high accuracy.

Optionally, as shown in FIGs. 11 and 12, one light-blocking unit 32 is correspondingly disposed below each light-concentrating unit 31; a central axis of the light-concentrating unit 31 is perpendicular to the plane of the effective photosensitive area of the first optical sensing chip 2; the light-blocking unit 32 corresponding to the light-concentrating unit 31 intersects the central axis of the light-concentrating unit 31; and a projection of the light-blocking unit 32 corresponding to the light-concentrating unit 31 onto the first optical sensing chip 2 is located within that of the light-concentrating unit 31 onto the first optical sensing chip 2. The light-blocking unit 32 may be in various shapes. For example, the light-blocking unit 32 may be square, circular, etc. The light-blocking unit 32 may be disposed at any position between the light-concentrating unit 31 and the plane of the effective photosensitive area of the first optical sensing chip 2. For example, the light-blocking unit 32 may be disposed on the upper surface of the first optical sensing chip 2 (as shown in FIG. 11), or may be disposed on the effective photosensitive area of the first optical sensing chip 2 without making a contact to the first optical sensing chip 2. The light-blocking units 32 corresponding to different light-concentrating units 31 may be disposed at different positions (as shown in FIG. 12). It should be understood that since the light-blocking unit 32 needs to block incident light at a small incident angle, i.e., to block the light generated after the first incident light in the incident light, which forms the included angle smaller than the angle threshold with the normal line of the plane of the effective photosensitive area of the first optical sensing chip 2, passes through the light-concentrating unit 31; while the first incident light is generally concentrated around the central axis of the light-concentrating unit 31 after it passes through the light-concentrating unit 31, and therefore, the light-blocking unit 32 corresponding to the light-concentrating unit 31 intersects the central axis of the light-concentrating unit 31. It should also be noted that, since the second incident light in the incident light, which forms the included angle larger than or equal to the angle threshold with the normal line of the plane of the effective photosensitive area of the first optical sensing chip 2, is generally concentrated at an edge of the light-concentrating unit 31 after it passes through the light-concentrating unit 31. Therefore, in the direction perpendicular to the plane of the effective photosensitive area of the first optical sensing chip 2, a projection of the light-blocking unit 32 corresponding to the light-concentrating unit 31 onto the first optical sensing chip 2 lies within that of the light-concentrating unit 31 onto the first optical sensing chip 2. That is, the vertical projection of the light-blocking unit 32 does not extend beyond that of the corresponding light-concentrating unit 31. In this way, it can prevent the light-blocking unit 32 from blocking the large-angle incident light while blocking the small-angle incident light. It can also prevent the light-blocking unit 32 from extending beyond the light-concentrating unit 31, which would otherwise block incident light passing through a position where no light-concentrating unit 31 is disposed by the light-blocking unit 32, thereby increasing the angle of the effective light entering the effective photosensitive area of the first optical sensing chip 2.

Optionally, as shown in FIGs. 11 and 12, the light uniformizing structure 3 further includes a dielectric layer 33. The dielectric layer 33 is disposed between the light-concentrating unit 31 and the first optical sensing chip 2, and the at least one light-blocking unit 32 is disposed within the dielectric layer 33. The dielectric layer 33 can provide a light-transmitting medium while supporting the light-concentrating unit 31. After the dielectric layer 33 is filled, the dielectric layer 33 and the light-concentrating unit 31 have similar refractive indexes, which helps prevent changes on the light propagation direction that would otherwise occur due to a difference in refractive index between the air and the light-concentrating unit 31 after the light exits the light-concentrating unit 31. Moreover, the dielectric layer 33 can seal the effective photosensitive area of the first optical sensing chip 2, protecting the plane of the effective photosensitive area of the first optical sensing chip 2 from being affected by foreign matters. The light-blocking unit 32 may be completely encapsulated within the dielectric layer 33, or may be disposed on the first optical sensing chip 2 with side and top portions of the light-blocking unit 32 encapsulated by the dielectric layer 33.

In a possible implementation, the light-blocking unit 32 includes a reflective layer or a light-absorbing layer.

The light-blocking unit 32 may include the reflective layer, which can reflect the light to block it. In one example, the reflective layer may be made of metal, for example, using a metal trace of the first optical sensing chip 2 or a metal layer within the first optical sensing chip 2 as the reflective layer. The light-blocking unit 32 may further include the light-absorbing layer, which can absorb the light to block it. In one example, the light-absorbing layer can be a black material or a coating. The light-blocking unit 32 can be implemented by disposing the black material or the coating within the dielectric layer 33 and/or on the surface of the effective photosensitive area of the first optical sensing chip 2.

The light-concentrating unit 31 may be a lens. In some other implementations, the light-concentrating unit 31 may also be a device with a light-concentrating function, such as a Fresnel zone plate and a metalens.

Optionally, as shown in FIGs. 11, 12, and 16 to 19, the light uniformizing structure 3 further includes a light-transmitting encapsulation layer 34. The light-transmitting encapsulation layer 34 is disposed on an upper surface of the dielectric layer 33, with at least one light-concentrating unit 31 located within the light-transmitting encapsulation layer 34. The light-transmitting encapsulation layer 34 protects the light-concentrating unit 31 while facilitating it to be fixedly bonded to the first light-transmitting layer 4.

Optionally, a refractive index of the light-concentrating unit 31 is larger than that of the light-transmitting encapsulation layer 34. If the refractive index of the light-concentrating unit 31 differs from that of the material of the light-transmitting encapsulation layer 34, the light-concentrating unit 31 can serve the light-concentrating function, i.e., can concentrate the light passing through the light-concentrating unit 31. Preferably, the difference in refractive index between the light-concentrating unit 31 and the light-transmitting encapsulation layer 34 is larger than 0.25, and more preferably, is larger than 0.4, which can achieve a better light-concentrating effect.

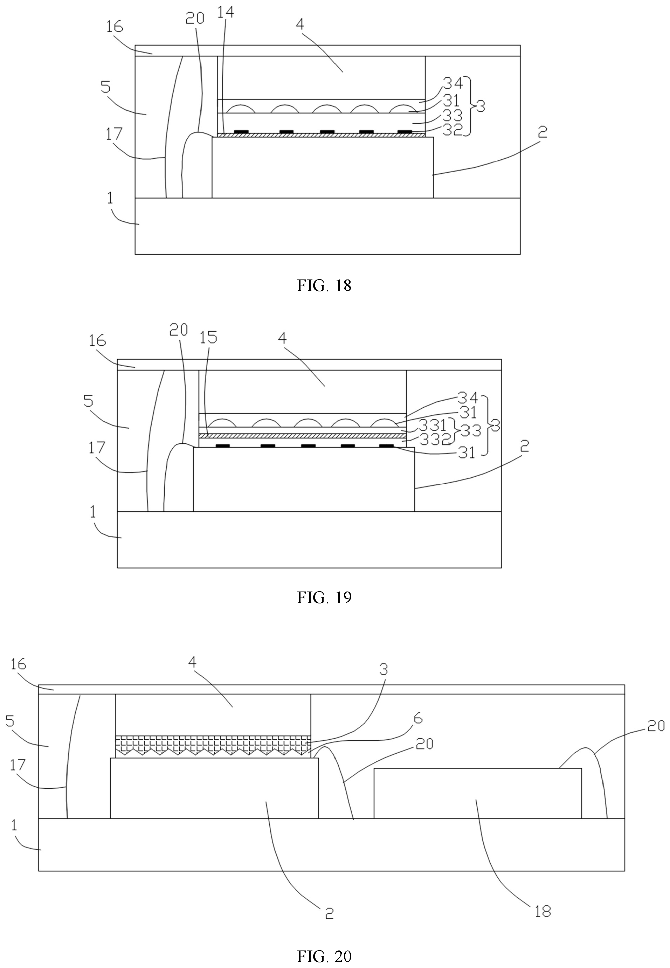

Optionally, as shown in FIGs. 16 to 18, the optical sensor further includes a second light filter layer 14, which allows light of a specific wavelength to enter the effective photosensitive area of the first optical sensing chip 2. As shown in FIG. 16, the second light filter layer 14 is bonded onto the first light-transmitting layer 4. As shown in FIG. 17, the second light filter layer 14 is disposed between the first light-transmitting layer 4 and the light uniformizing structure 3. In a case of the light uniformizing structure 3 including the light-transmitting encapsulation layer 34, the second light filter layer 14 has an upper surface bonded to the first light-transmitting layer 4, and a lower surface bonded to the light-transmitting encapsulation layer 34. As shown in FIG. 18, the second light filter layer 14 is disposed between the dielectric layer 33 and the first optical sensing chip 2, having the upper surface bonded to the dielectric layer 33 and the lower surface bonded to the first optical sensing chip 2. The second light filter layer 14 may be a color filter layer or an infrared cut filter layer.

Optionally, as shown in FIG. 19, the dielectric layer 33 includes a first sub-dielectric layer 331 and a second sub-dielectric layer 332 arranged vertically, and the optical sensor further includes a third light filter layer 15 which is disposed between the first sub-dielectric layer 331 and the second sub-dielectric layer 332. The third light filter layer 15 allows light of a specific wavelength to enter the effective photosensitive area of the first optical sensing chip 2. The third light filter layer 15 may be a color filter layer or an infrared cut filter layer. The light-blocking unit 32 may be disposed within the first sub-dielectric layer 331 or the second sub-dielectric layer 332. When a plurality of light-blocking units 32 correspond to each light-concentrating unit 31, the light-blocking units 32 corresponding to each light-concentrating unit 31 may be disposed within the first sub-dielectric layer 331 and/or the second sub-dielectric layer 332. When a single light-blocking unit 32 corresponds to each light-concentrating unit 31, the light-blocking unit 32 may be disposed within either the first sub-dielectric layer 331 or the second sub-dielectric layer 332, and the light-blocking units 32 corresponding to different light-concentrating units 31 may be disposed at different positions.

Optionally, the light-blocking unit 32 includes a circular light-blocking unit. In the direction perpendicular to the first optical sensing chip 2, a central axis of the light-blocking unit 32 corresponding to the light-concentrating unit 31 coincides with that of the light-concentrating unit 31. Thus, it can block the light concentrated near the axis after the light passes through the light-concentrating unit 31, thereby blocking the first incident light, which forms the included angle smaller than the angle threshold with the normal line of the plane of the effective photosensitive area of the first optical sensing chip 2. This can attenuate the small-angle incident light detected by the first optical sensing chip 2, thereby improving the application performance of the optical sensor.

In one possible implementation, a diameter of the light-blocking unit 32 ranges from 1 µm to 10 µm, and/or a height of the light-concentrating unit 31 ranges from 0.5 µm to 8 µm. In this embodiment, the light-concentrating unit 31 may be a lens, and a height of the light-concentrating unit 31 is a distance from a top of the lens to a surface, in contact with the light-concentrating unit 31, of the dielectric layer 33. In a preferred example, the height of the light-concentrating unit 31 ranges from 1 µm to 5 µm.

Optionally, the optical sensor includes a plurality of light-concentrating units 31, which are arranged in an array. The plurality of light-concentrating units 31 are arranged in a square periodic pattern, forming a light-concentrating unit 31 array. It should be understood that, because the first incident light, which forms the included angle smaller than the angle threshold with the normal line of the plane of the effective photosensitive area of the first optical sensing chip 2, will be blocked by the light-blocking unit 32 after it passes through the light-concentrating unit 31, a certain spacing can be allowed between any adjacent light-concentrating units 31, and the first incident light, which forms the included angle smaller than the angle threshold with the normal line of the plane of the effective photosensitive area of the first optical sensing chip 2, can illuminate a portion where no light-concentrating unit 31 is disposed. For example, when the light passes between any adjacent light-concentrating units 31 or through the position where no light-concentrating unit 31 is disposed, it can directly illuminate the effective photosensitive area of the first optical sensing chip 2. This enables detection of the first incident light, which forms the included angle smaller than the angle threshold with the normal line of the plane of the effective photosensitive area of the first optical sensing chip 2.

In one possible implementation, an arrangement period of the light-concentrating units 31 ranges from 4 µm to 40 µm, and an aperture of each light-concentrating unit 31 ranges from 4 µm to 40 µm, where the arrangement period is larger than or equal to the aperture of each light-concentrating unit 31. The arrangement period of the light-concentrating units 31 refers to a distance between centers of two adjacent light-concentrating units 31 in the light-concentrating unit 31 array; and the aperture of each light-concentrating unit 31 refers to an effective clear aperture of each light-concentrating unit 31. Since there may be the certain spacing between adjacent light-concentrating units 31, and the spacing between adjacent light-concentrating units 31 is equal to a difference between the arrangement period of the light-concentrating units 31 and the aperture of each light-concentrating unit 31, it requires the arrangement period to be larger than or equal to the aperture of each light-concentrating unit 31.

In one preferred example, the arrangement period of the light-concentrating units 31 ranges from 5 µm to 25 µm, the aperture of each light-concentrating unit 31 ranges from 5 µm to 25 µm, and the arrangement period is larger than or equal to the aperture of each light-concentrating unit 31.

In one possible implementation, in the direction perpendicular to the plane of the effective photosensitive area of the first optical sensing chip 2, a distance between the light-concentrating unit 31 and the lower surface of the corresponding light-blocking unit 32 ranges from 5 µm to 30 µm. By adjusting the distance between the light-concentrating unit 31 and the lower surface of the light-blocking unit 32, a relative position between the light-blocking unit 32 and a focal plane of the light-concentrating unit 31 may be adjusted, followed by adjustment on the amount of the light blocked by the light-blocking unit 32. As a result, this allows for light blocking as needed and enables adjustment on a degree of attenuating the small-angle incident light.

In some embodiments, as shown in FIGs. 1 to 12 and FIGs. 16 to 25, a light-transmitting conductive shielding layer 16 is disposed on a top layer of the optical sensor, and electrically connected to a ground line of the substrate 1. When the optical sensor is applied under a screen, a screen module above the optical sensor can generate an interference signal across the entire upper surface of the optical sensor. Therefore, in this embodiment, the light-transmitting conductive shielding layer 16 is disposed on the top layer of the optical sensor, covering the entire substrate 1 and a structure thereon. This can effectively shield against the interference signal, increase a signal-to-noise ratio with ensuring light transmittance, and improve the performance of the optical sensor.

Optionally, the light-transmitting conductive shielding layer 16 is formed as an electrical shielding layer by sputtering, evaporation coating, printing, or spraying on the light-shielding encapsulation layer 5 and the first light-transmitting layer 4. Preferably, the light-transmitting conductive shielding layer 16 is made of an organic or inorganic material with the light transmittance larger than 90%. More preferably, the light-transmitting conductive shielding layer 16 is made of a material including at least one of indium tin oxide, indium zinc oxide, transparent conductive ink (primarily composed of a conductive polymer PEDOT), nano-silver, or a metal grid, to meet a requirement of the effective photosensitive area of the first optical sensing chip 2 for the light transmittance.

The light-transmitting conductive shielding layer 16 is electrically connected to the ground line of the substrate 1 by means of a connecting member 17; the connecting member 17 is one of a circuit board, a conductive pillar, or a bonding wire 20; and the light-shielding encapsulation layer 5 encapsulates the connecting member 17. The circuit board may be disposed perpendicular to the substrate 1 or may be inclined. Two ends of the circuit board are electrically connected to the light-transmitting conductive shielding layer 16 and the substrate 1 respectively. Specifically, the circuit board is electrically connected to the substrate 1 by means of a silver paste layer, a solder layer, or the DAF, thereby achieving electrical connection between it and the ground line of the substrate 1. The circuit board may be a printed circuit board, a flexible circuit board, or any other circuit board with a conductive trace. The conductive pillar may be disposed perpendicular to the substrate 1 or may be inclined. Two ends of the conductive pillar are electrically connected to the light-transmitting conductive shielding layer 16 and the substrate 1 respectively. Specifically, the conductive pillar is electrically connected to the substrate 1 by means of the silver paste layer, the solder layer, or the DAF. Preferably, the conductive pillar may be a metal pillar, and more preferably, a copper pillar. Two ends of the bonding wire 20 are electrically connected to the light-transmitting conductive shielding layer 16 and the substrate 1 respectively. A top end of the bonding wire 20 is electrically connected to the light-transmitting conductive shielding layer 16, and a bottom end of the bonding wire 20 is electrically connected to a circuit inside the substrate 1, thereby achieving electrical connection between it and the ground line of the substrate 1. A diameter of the bonding wire 20 may be larger than that of a bonding wire 20 connecting the first optical sensing chip 2 to the substrate 1, and its material may be the same as or different from that of the bonding wire 20 connecting the first optical sensing chip 2 to the substrate 1. The connecting member 17 is the circuit board, the conductive pillar, or the bonding wire 20, which offers easily available materials and a simple packaging process.

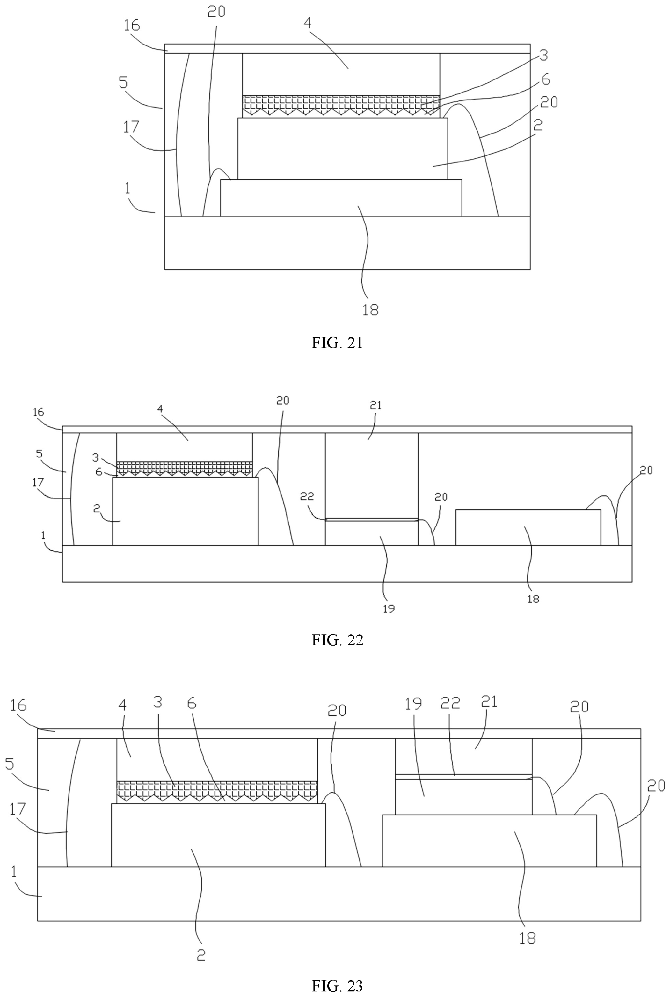

In some embodiments, as shown in FIGs. 20 and 21, the optical sensor further includes a processing chip 18. The processing chip 18 is disposed on the substrate 1, electrically connected to the substrate 1, and fixedly bonded to the substrate 1 by means of the silver paste, the DAF, or the water-based optical adhesive. The processing chip 18 is electrically connected to the substrate 1 by means of the bonding wire 20. The first optical sensing chip 2 is electrically connected to the processing chip 18, for example, by means of the bonding wire 20. The processing chip 18 is capable of processing an electrical signal transmitted from the first optical sensing chip 2 and outputting a processing result to the external. The light-shielding encapsulation layer 5 encapsulates the processing chip 18, providing sealed protection for it.

Optionally, as shown in FIG. 20, the first optical sensing chip 2 and the processing chip 18 are laid on the substrate 1, and are fixedly bonded to the substrate 1 by means of the silver paste, the DAF, or the water-based optical adhesive.

Optionally, as shown in FIG. 21, the first optical sensing chip 2 is disposed on the processing chip 18, and is fixedly bonded to the processing chip 18 by means of the silver paste, the DAF, or the water-based optical adhesive. Compared with the embodiment shown in FIG. 20, this reduces an area of the substrate 1.

The processing chip 18 includes at least one of an analog front-end chip, a control chip, or a signal processing chip, and a type of the processing chip 18 is selected as needed.

In some embodiments, as shown in FIGs. 22 to 25, the optical sensor further includes a second optical sensing chip 19. The second optical sensing chip 19 is disposed on the substrate 1 and electrically connected to the substrate 1. A second light-transmitting layer 21 is disposed on the second optical sensing chip 19, having a vertical projection at least covering an effective photosensitive area of the second optical sensing chip 19. The light-shielding encapsulation layer 5 encapsulates side portions of the second optical sensing chip 19 and the second light-transmitting layer 21, allowing the light to enter the effective photosensitive area of the second optical sensing chip 19.

The second light-transmitting layer 21 is the glass plate or the transparent organic plate. The transparent organic plate may be the phenolic resin plate, the polyethylene terephthalate-1,4-cyclohexanedimethyleneterephthalate (PETG) plate, the polymethyl methacrylate (PMMA) plate, the polyimide (PI) plate the polyethylene glycol terephthalate (PET) plate. In a case of the second light-transmitting layer 21 being the glass plate, the second light-transmitting layer 21 is fixedly bonded to the second optical sensing chip 19 by means of the light-transmitting adhesive 22. In a case of the second light-transmitting layer 21 being the transparent organic plate, the transparent organic plate may be fixedly bonded to the second optical sensing chip 19 by means of the light-transmitting adhesive 22, or may be directly molded onto the second optical sensing chip 19 using the transparent organic material. A specific method for bonding the second light-transmitting layer 21 to the second optical sensing chip 19 is adjusted based on hardness of the transparent organic material after it is formed into a plate. Preferably, the light-transmitting adhesive 22 is the DAF adhesive or the water-based optical adhesive.

Preferably, the first optical sensing chip 2 is used for detecting visible light, and the second optical sensing chip 19 is used for detecting infrared light.

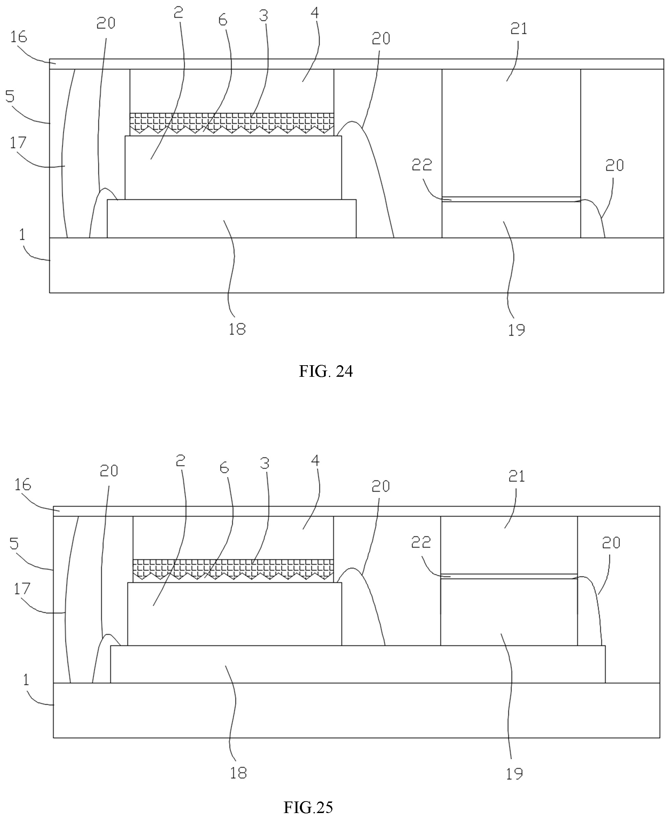

The optical sensor further includes the processing chip 18, and the second optical sensing chip 19 is disposed on the processing chip 18 or the substrate 1. The second optical sensing chip 19 is fixedly bonded to the processing chip 18 or the substrate 1 by means of the silver paste, the DAF, or the water-based optical adhesive, and is electrically connected to the processing chip 18 by means of the bonding wire 20. As shown in FIG. 22, the first optical sensing chip 2, the second optical sensing chip 19, and the processing chip 18 are laid on the substrate 1. As shown in FIG. 23, the first optical sensing chip 2 is disposed on the substrate 1, and the second optical sensing chip 19 is disposed on the processing chip 18. As shown in FIG. 24, the second optical sensing chip 19 is disposed on the substrate 1, and the first optical sensing chip 2 is disposed on the processing chip 18. As shown in FIG. 25, both the first optical sensing chip 2 and the second optical sensing chip 19 are disposed on the processing chip 18, and in this case, an area of the optical sensor is minimal.

It has been verified that, in an application environment under a certain screen and under a same incident light's intensity and angle, comparison is made between an optical sensor without the light uniformizing structure 3 (but otherwise identical in other structures) and the optical sensor in the embodiment of the present application. The half-angle of the effective field of view above the first optical sensing chip 2 of the optical sensor without the light uniformizing structure 3 is about 37 degrees, whereas the half-angle of the effective field of view of the optical sensor in the embodiment of the present application can be increased to above 55 degrees, significantly enlarging the angle of the effective field of view.

A height of the optical sensor in the embodiment of the present application can be controlled to be about 0.6 mm. Compared with the prior art, where a bracket is disposed outside an entire encapsulation structure to place a light uniformizing structure (disposing the bracket significantly increases the overall length, width, and height of the optical sensor), the present application embeds the light uniformizing structure inside the encapsulation structure, effectively reducing the overall size of the optical sensor.

The present application further discloses an electronic device, including the optical sensor described in the above embodiments. The electronic device may be an electronic device with a screen, where the optical sensor is disposed under the screen. The electronic device may be a laptop, a mobile phone, a tablet computer, a desktop computer, a gaming device, an in-vehicle electronic device, a wearable smart device, etc. With arrangement of the light-shielding encapsulation layer 5, there is no need for filling the periphery of the optical sensor with foam for light shielding, thereby, in machining the electronic device, reducing or eliminating the use of the foam, shrinking the module's size, and lowering a cost.

In the description of the present application, it needs to be noted that, orientations or positional relationships indicated by the terms "center", "longitudinal", "transversal", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. are based on orientations or positional relationships shown in the drawings, and are only for the convenience of describing the present invention and simplifying the description, rather than indicating or implying that an apparatus or element referred to must have a specific orientation, be constructed and operated in a specific orientation, and therefore cannot be understood as a limitation on the present application.

In the present application, unless otherwise specified and limited, the terms "installed", "connected", "connection", "fixed", and the like should be understood in a broad sense, such as fixed connection, detachable connection, integration, mechanical connection, electric connection, direct connection, indirect connection through an intermediate medium, internal communication of two elements, or an interaction relationship between two elements, unless otherwise specified. For those of ordinary skill in the art, specific meanings of the above terms in the present application can be understood according to specific circumstances.

In the description of this specification, descriptions of the reference terms "this embodiment", "one embodiment", "some embodiments", "example", "specific example", or "some examples", etc. mean that specific features, structures, materials, or characteristics described in connection with the embodiments or examples are included in at least one embodiment or example of the present application. In this specification, schematic expressions of the above terms need not be directed to the same embodiment or example. Moreover, the described specific feature, structure, material, or characteristic can be combined in any suitable way in one or more embodiments or examples. In addition, different embodiments or examples described in the specification, as well as features of different embodiments or examples may be combined by those skilled in the art without contradicting each other.

Moreover, the terms "first" and "second" are only for the purpose of description, and cannot be interpreted as indicating or implying relative importance or implicitly indicating the quantity of the indicated technical features. Therefore, the features defined with "first" and "second" can explicitly or implicitly include one or more features. In the description of the present application, "a plurality of" means at least two, such as two or three, unless otherwise specified.
Described above is merely the preferred embodiment of the present application and is not to be construed as limiting the present application. Any changes, equivalent substitutions and simple improvements made on the material contents of the present application shall all fall within the protection scope of the present application.

## Claims

1. An optical sensor, comprising a substrate (1), a first optical sensing chip (2), a light uniformizing structure (3), a first light-transmitting layer (4), and a light-shielding encapsulation layer (5),
the first optical sensing chip (2) being disposed on the substrate (1) and electrically connected to the substrate (1),
the light uniformizing structure (3) being disposed above or on the first optical sensing chip (2) and having a vertical projection at least covering an effective photosensitive area of the first optical sensing chip (2),
the first light-transmitting layer (4) being disposed above or on the light uniformizing structure (3) and having a vertical projection at least covering the effective photosensitive area of the first optical sensing chip (2), and
the light-shielding encapsulation layer (5) being disposed on the substrate (1) and encapsulating side portions of the first optical sensing chip (2), the light uniformizing structure (3), and the first light-transmitting layer (4).

2. The optical sensor according to claim 1, wherein the light uniformizing structure (3) is of a structure with a flat upper surface and a lower surface provided with a plurality of first protrusions, and :
(a) a first light-transmitting adhesive layer (6) is disposed under the light uniformizing structure (3), having a refractive index smaller than that of the light uniformizing structure (3); and the light uniformizing structure (3) is bonded to the first optical sensing chip (2) or to a first transparent layer (7) disposed on the first optical sensing chip (2) by means of the first light-transmitting adhesive layer (6), and a vertical projection of the first transparent layer (7) at least covers the effective photosensitive area of the first optical sensing chip (2);
(b) a planarization layer (8) is disposed under the light uniformizing structure (3); a plurality of second protrusions are arranged on an upper surface of the planarization layer (8), and fill a gap between the first protrusions on the lower surface of the light uniformizing structure (3); a lower surface of the planarization layer (8) is a flat plane; a refractive index of the planarization layer (8) is smaller than that of the light uniformizing structure (3); the lower surface of the planarization layer (8) is bonded to the first optical sensing chip (2) or to a second transparent layer (9) disposed on the first optical sensing chip (2); and a vertical projection of the second transparent layer (9) at least covers the effective photosensitive area of the first optical sensing chip (2);or,
(c) a cofferdam (10) is disposed around a periphery below the light uniformizing structure (3); the cofferdam (10) is bonded to the first optical sensing chip (2) to form an air gap (11) between the light uniformizing structure (3) and the first optical sensing chip (2), or the cofferdam (10) is bonded to a third transparent layer (12) disposed on the first optical sensing chip (2) to form an air gap (11) between the light uniformizing structure (3) and the third transparent layer (12); a vertical projection of the air gap (11) at least covers the effective photosensitive area of the first optical sensing chip (2); and a vertical projection of the third transparent layer (12) at least covers the effective photosensitive area of the first optical sensing chip (2).

3. The optical sensor according to claim 2, wherein the optical sensor further comprises a first light filter layer (13), the first light filter layer (13) being bonded onto the first light-transmitting layer (4) or disposed between the first light-transmitting layer (4) and the light uniformizing structure (3).

4. The optical sensor according to claim 1, wherein the light uniformizing structure (3) comprises at least one light-concentrating unit (31) and at least one light-blocking unit (32); the at least one light-blocking unit (32) is correspondingly disposed below each light-concentrating unit (31); the at least one light-concentrating unit (31) at least covers the effective photosensitive area of the first optical sensing chip (2); and the light-blocking unit (32) corresponding to the light-concentrating unit (31) is located between the light-concentrating unit (31) and the effective photosensitive area of the first optical sensing chip (2); the light-blocking unit (32) is used for blocking, after first incident light in incident light is concentrated by the light-concentrating unit (31) corresponding to the light-blocking unit (32), concentrated light from reaching the effective photosensitive area of the first optical sensing chip (2); and an included angle between the first incident light and a normal line of a plane of the effective photosensitive area of the first optical sensing chip (2) is smaller than an angle threshold which is smaller than 90 degrees.

5. The optical sensor according to claim 4, wherein one light-blocking unit (32) is correspondingly disposed below each light-concentrating unit (31); a central axis of the light-concentrating unit (31) is perpendicular to the plane of the effective photosensitive area of the first optical sensing chip (2); the light-blocking unit (32) corresponding to the light-concentrating unit (31) intersects the central axis of the light-concentrating unit (31); and a projection of the light-blocking unit (32) corresponding to the light-concentrating unit (31) onto the first optical sensing chip (2) is located within that of the light-concentrating unit (31) onto the first optical sensing chip (2).

6. The optical sensor according to claim4, wherein the light uniformizing structure (3) further comprises a dielectric layer (33); the dielectric layer (33) is disposed between the light-concentrating unit (31) and the first optical sensing chip (2); and the at least one light-blocking unit (32) is disposed within the dielectric layer (33).

7. The optical sensor according to claim 6, wherein the light uniformizing structure (3) further comprises a light-transmitting encapsulation layer (34); the light-transmitting encapsulation layer (34) is disposed on an upper surface of the dielectric layer (33); and the at least one light-concentrating unit (31) is located within the light-transmitting encapsulation layer (34).

8. The optical sensor according to claim 6 or 7, wherein the optical sensor further comprises a second light filter layer (14), the second light filter layer (14) being bonded onto the first light-transmitting layer (4), or disposed between the first light-transmitting layer (4) and the light uniformizing structure (3), or disposed between the dielectric layer (33) and the first optical sensing chip (2).

9. The optical sensor according to claim 6, wherein the dielectric layer (33) comprises a first sub-dielectric layer (331) and a second sub-dielectric layer (332) arranged vertically; and the optical sensor further comprises a third light filter layer (15), the third light filter layer (15) being disposed between the first sub-dielectric layer (331) and the second sub-dielectric layer (332).

10. The optical sensor according to claim 7, wherein a refractive index of the light-concentrating unit (31) is larger than that of the light-transmitting encapsulation layer (34).

11. The optical sensor according to claim 5, wherein the light-blocking unit (32) comprises a circular light-blocking unit; and in a direction perpendicular to the first optical sensing chip (2), a central axis of the light-blocking unit (32) corresponding to the light-concentrating unit (31) coincides with that of the light-concentrating unit (31).

12. The optical sensor according to claim 1, wherein a light-transmitting conductive shielding layer (16) is disposed on a top layer of the optical sensor, and is electrically connected to a ground line of the substrate (1).

13. The optical sensor according to claim 12, wherein the light-transmitting conductive shielding layer (16) is electrically connected to the ground line of the substrate (1) by means of a connecting member (17); the connecting member (17) is one of a circuit board, a conductive pillar, or a bonding wire; and the light-shielding encapsulation layer (5) encapsulates the connecting member (17).

14. The optical sensor according to claim 1, wherein the optical sensor further comprises one of the following alternative structures:
(a) a processing chip (18), wherein:
the processing chip (18) is disposed on the substrate (1) and electrically connected to the substrate (1); the first optical sensing chip (2) is electrically connected to the processing chip (18); the first optical sensing chip (2) and the processing chip (18) are laid on the substrate (1), or the first optical sensing chip (2) is disposed on the processing chip (18); and the light-shielding encapsulation layer (5) encapsulates the processing chip (18);or,
(b) a second optical sensing chip (19),wherein:
the second optical sensing chip (19) is disposed on the substrate (1) and electrically connected to the substrate (1); a second light-transmitting layer (21) is disposed on the second optical sensing chip (19), having a vertical projection at least covering an effective photosensitive area of the second optical sensing chip (19); and the light-shielding encapsulation layer (5) encapsulates side portions of the second optical sensing chip (19) and the second light-transmitting layer (21).

15. The optical sensor according to claim **14,** wherein the first optical sensing chip (2) is used for detecting visible light, and the second optical sensing chip (19) is used for detecting infrared light.
